# FASCICULE DE BREVET EUROPEEN

(11) **EP 1 830 401 B1**
(45) Date de publication et mention de la délivrance du brevet: **03.11.2010**
(21) Numéro de dépôt: 07354008.0
(22) Date de dépôt: 13.02.2007
(51) Int. Cl.: H01L 21/762

(54) **Microstructure pour la formation d'un substrat en silicium et germanium sur isolant et de type Si1-XGeX**
Mikrostruktur zur Bildung eines Substrats aus Silizium und Germanium auf einem Isolator und vom Typ Si1-XGeX
Microstructure for forming a silicon and germanium substrate on an insulator of the Si1-XGeX type

(30) Priorité: 01.03.2006 FR 0601851
(43) Date de publication de la demande: 05.09.2007
(73) Titulaire: Commissariat à l'Énergie Atomique et aux Énergies Alternatives, 75015 Paris (FR)
(72) Inventeur: Damlencourt, Jean-Francois, 38120 Saint-Egrève (FR); Costa, Rémi, 05400 Veynes (FR)
(74) Mandataire: Hecké, Gérard

(56) Documents cités:
- US-A- 5 906 951
- US-B1- 6 689 211
- NAKAHARAI S ET AL: "Characterization of 7-nm-thick strained Ge-on-insulator layer fabricated by Ge-condensation technique" APPLIED PHYSICS LETTERS AIP USA, vol. 83, no. 17, 27 octobre 2003 (2003-10-27), pages 3516-3518, XP002403261 ISSN: 0003-6951

## Description

### Domaine technique de l'invention

L'invention concerne une microstructure destinée à la formation d'un substrat en silicium et germanium sur isolant et de type Si_{1-Xf}Ge_{Xf}, avec Xf compris entre une première valeur non nulle et 1, et formée par un empilement d'un substrat en silicium sur isolant et d'une première couche initiale en alliage de silicium et germanium de type Si_{1-X1}Ge_{X1'} avec X1 compris strictement entre 0 et Xf.

### État de la technique

La technologie microélectronique actuelle, basée sur le silicium, arrive aux limites des possibilités offertes par ce matériau. Les besoins croissants en dispositifs électroniques toujours plus performants, plus rapides et plus économes en énergie ont conduit à étudier de nouvelles solutions.

L'industrie microélectronique s'est alors tournée vers le germanium, qui est entièrement compatible avec la technologie développée pour le silicium et qui présente la même structure cristalline que le silicium, mais avec des meilleures propriétés notamment en termes de mobilité de porteurs de charge.

Une application particulière concerne les transistors à effet de champ semiconducteur oxyde métallique de type p (pMOSFET : « metal-oxyde-semiconductor field-effect transistor). L'article « Selectively-formed high mobility SiGe-On-Insulator pMOSFETs with Ge-rich strained surface channels using local condensation technique » de T. Tezuka et al. (2004 IEEE Symposium on VLSI Technology Digest of technical papers) décrit notamment la réalisation d'un pMOSFET, dont l'amélioration des performances est particulièrement sensible pour des transistors appauvris en porteurs de charge (FD pMOSFET) réalisés en germanium.

Pour la fabrication de substrats en germanium sur isolant (GOI ou GeOI: « Germanium On Insulator), une première technique utilise la technologie « Smart Cut » (marque déposée), initialement développée pour la fabrication de substrats en silicium sur isolant (SOI: « Silicon On Insulator »), décrite notamment dans l'article « 200mm Germanium-On-Insulator (GeOl) structures realized from epitaxial wafers using the Smart Cut™ technology » de C. Deguet et al. (Proceedings ECS 2005 conference, Québec). Cette technologie est basée sur le report, sur un substrat en silicium, d'une couche de germanium, déposée sur une couche d'oxyde de silicium SiO₂ formant une couche isolante. Le substrat en GOI ainsi obtenu est du type pleine plaque. Cependant, cette technologie présente un coût très élevé et des transistors de type nMOSFET sont très difficiles à réaliser.

Une deuxième technologie est basée sur le principe de la recristallisation latérale, notamment décrit dans l'article « High-quality single-crystal Ge on insulator by liquid-phase epitaxy on Si substrates » de Y. Liu et al. (Applied Physics Letters, vol.84, n°14, April 5, 2004), permettant de réaliser un substrat en GOI du type localisé. La technique consiste à déposer localement sur un substrat standard en silicium une couche de nitrure, qui formera l'isolant, puis ensuite à déposer au-dessus une couche plus étendue de germanium, qui sera alors localement en contact avec le substrat en silicium. Une fois encapsulé, l'empilement est chauffé brièvement à la température de fusion du germanium puis refroidi. La solidification du germanium fondu s'amorce sur le silicium du substrat (germe monocristallin), puis le front se propage formant localement une couche de germanium monocristalline sur isolant. Cependant, cette technique de réalisation de substrat en GOI localisé est lourde, du fait des problèmes de stabilité d'interfaces, et la recristallisation est limitée à la fois en étendue et en géométrie.

Une troisième technique de fabrication connue utilise la technique de condensation germanium, permettant également de réaliser des substrats en GOI localisés. Cette technique repose sur la miscibilité totale du germanium et du silicium (même structure cristalline) et sur la différence d'affinité chimique entre le germanium et le silicium vis-à-vis de l'oxygène, notamment mises en évidence dans l'article « A novel Fabrication Technique of Ultrathin and Relaxed SiGe Buffer Layers with High Ge Fraction for Sub-100nm Strained Silicon-On-Insulator MOSFETs » de T. Tezuka et al. (Jpn. J. Appl. Phys. Vol. 40 (2001) pp.2866-2874 Part1, No. 4B, April 2001).

L'article « Characterization of 7-nm-thick strained Ge-on-insulator layer fabricated by Ge-condensation technique » de S. Nakaharai et al. (Applied Physics Letters, vol. 83, n°17, October 27, 2003) décrit notamment le principe de fabrication d'un substrat en SGOI ou GOI par condensation germanium.

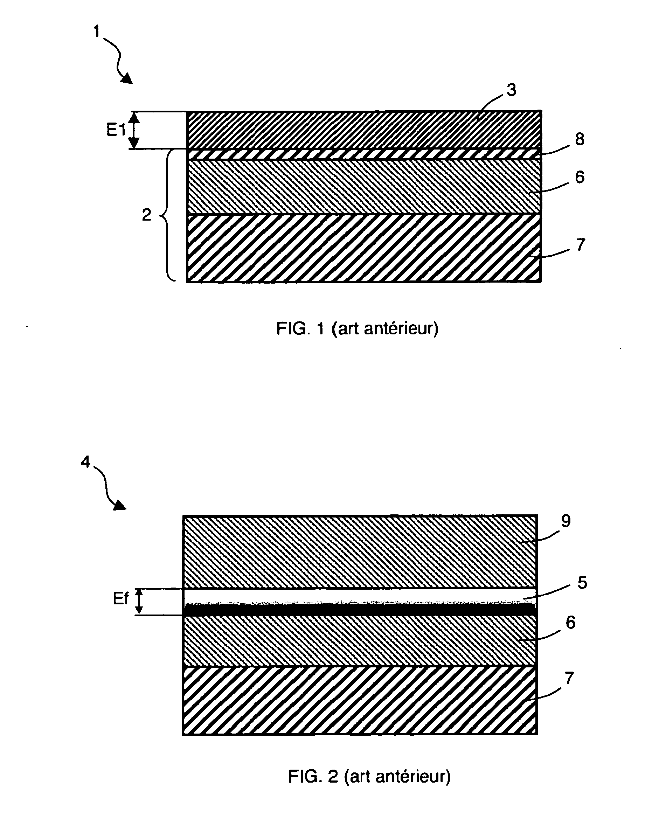

Comme représenté schématiquement sur les figures 1 et 2, une microstructure 1, formée par un empilement d'un substrat 2 en SOI et d'une couche 3 en alliage de silicium et germanium de type Si_{1-X1}Ge_{X1} (figure 1), est destinée à la formation d'un substrat 4 comprenant une couche finale 5 en alliage de silicium et germanium de type Si_{1-Xf}Ge_{Xf} (figure 2).

Le substrat 2 en SOI de la microstructure 1 de départ comporte une couche 6 d'oxyde de silicium SiO₂, enterrée entre deux couches de silicium, une couche épaisse 7 et une couche fine 8, sur laquelle est déposée la couche 3 initiale en Si_{1-X1}Ge_{X1'} La concentration finale Xf de germanium dans la couche 5 du substrat 4 est comprise entre une première valeur non nulle et 1 et la concentration initiale X1 de germanium dans la couche 3 de la microstructure 1 est comprise strictement entre 0 et la concentration finale Xf de germanium dans la couche 5 du substrat 4.

Le procédé de condensation germanium consiste à réaliser un traitement d'oxydation thermique, de préférence à haute température, du silicium de l'empilement des couches de la microstructure 1 de départ. Le silicium ayant une meilleure affinité chimique envers l'oxygène, le germanium n'est pas oxydé. Comme représenté sur la figure 2, l'oxydation thermique entraîne alors la consommation du silicium de l'ensemble de l'empilement du substrat 2 en SOI et de la couche 3 en Si_{1-X1}Ge_{X1}, pour former une couche supérieure 9 de SiO₂, disposée sur le dessus du substrat 4 (figure 2). La couche fine 8 de silicium du substrat 2 en SOI, disposée initialement entre la couche 3 en Si_{1-X1}Ge_{X1} et la couche 6 de SiO₂ enterrée de la microstructure 1, a été consommée pendant l'oxydation thermique et est remontée dans la couche supérieure 9 en SiO₂.

Sur la figure 2, le germanium n'étant pas soluble dans le SiO₂, la couche 5 enrichie en germanium a été rejetée contre la couche 6 de SiO₂ enterrée et présente alors une épaisseur finale Ef, inférieure à l'épaisseur initiale E1 de la couche 3 en Si_{1-X1}Ge_{x1'}

Comme décrit dans l'article « Oxidation of Sii-xGex alloys at atmospheric and elevated pressure » de D.C. Paine et al. (J. Appl. Phys. 70(9), November 1, 1991), le procédé de condensation germanium peut se poursuivre jusqu'à la consommation complète du silicium, de manière à obtenir une couche 5 comprenant exclusivement du germanium, pour former alors un substrat 4 en GOI, avec une concentration finale Xf de germanium égale à 1. Dans le cas où le silicium n'est pas complètement consommé, le substrat 4 est alors un substrat en SGOI, avec une concentration finale Xf de germanium de la couche 5 comprise strictement entre 0 et 1.

Cependant, un problème majeur de cette technique de condensation germanium, pour la fabrication d'un substrat 4 comprenant une couche 5 en Si_{1-Xf}Ge_{Xf}, est la relaxation des contraintes dans la couche finale 5 enrichie en germanium. Lors de l'oxydation de la couche 3 en Si_{1-X1}Ge_{X1} de la microstructure 1, il y a compétition entre oxydation du silicium et diffusion du germanium. Un fort gradient de composition peut conduire à un état de contrainte locale, telle que la couche 5 se relaxe plastiquement. Il en résulte alors l'apparition de réseaux croisés de dislocation dans la couche 5, engendrant notamment une mauvaise qualité du substrat 4.

Par ailleurs, la technique de condensation germanium peut être utilisée indifféremment pour des couches épaisses, à savoir supérieures à 1µm et à l'épaisseur critique de relaxation Ec, comme décrit dans l'article « Calculation of critical layer thickness considering thermal strain in Si1-XGeX/Si strained-layer heterostructures » de Jingyun Huang et al. (J. Apply. Phys. 83 (1), 1 January 1998), ou pour des fines couches, à savoir inférieures à l'épaisseur critique de relaxation Ec.

Cependant, pour obtenir au final un substrat en GOI ou en SGOI épais, la condensation germanium à partir de couches épaisses suppose des temps d'oxydation longs, car une décroissance de la vitesse d'oxydation est observée en fonction de l'épaisseur de la couche 9 de SiO₂ formée sur le substrat 4. De plus, la microstructure 1 de départ est réalisée, de préférence, par croissance métamorphique, ce qui entraîne la présence de dislocations dans l'empilement de ces couches, qui sont alors relaxées plastiquement.

Par ailleurs, en partant d'une couche 3 en Si_{1-X1}Ge_{X1} relativement fine, la couche 3 est consommée lors de la condensation et la couche 5 obtenue est alors relativement fine. À titre d'exemple, en partant d'une couche de Si_{1-X1}Ge_{X1} avec une concentration initiale X1 de germanium de 10% (X1=0,1) et une épaisseur initiale E1 de 100nm, il est possible d'obtenir un substrat 4 en GOI, avec une épaisseur finale Ef de la couche 5 de l'ordre de 10nm.

Cependant, d'un point de vue technologique, il est très difficile de former des composants sur un substrat 4 en GOI aussi fin. Un épaississement de la couche 5 est donc nécessaire, avec tous les problèmes que cela peut comporter, notamment une fragilité de l'interface entre la couche 5 en germanium et la couche 6 en SiO₂ enterrée et la difficulté d'obtenir un matériau monocristallin par épitaxie sur une couche de germanium aussi fine sur isolant. De plus, la surface sur laquelle est réalisée l'épitaxie doit être toujours propre. Or, le point de fusion du germanium est très bas, ce qui empêche la réalisation d'un traitement haute température permettant de nettoyer la surface.

Par ailleurs, l'article « High Germanium Content Strained SGOI by Oxidation of Amorphous SiGe Film on SOI Substrates » de F. Gao et al. (Electrochemical and Solid-State Letters, 8 (12) G337-G340 (2005)), décrit un procédé particulier de réalisation d'un substrat par condensation germanium consistant à déposer une couche amorphe en alliage de silicium et germanium directement sur le substrat en SOI. Cependant, la couche en alliage de silicium et germanium est déposée directement sur le substrat en SOI et recristallise lors du traitement d'oxydation haute température de la microstructure. Il en résulte alors l'obtention d'un substrat ne présentant pas des caractéristiques optimales en termes de contraintes et présentant des défauts d'un point de vue cristallin.

US 5 906 951 (25-05-1999) décrit une microstructure destinée à la formation d'un substrat en silicium et germanium sur isolant et de type Si_{1-xf}Ge_{xf}, avec Xf compris entre une première valeur non nulle et 1, et formée par un empilement d'un substrat en silicium sur isolant et d'une première couche initiale en alliage de silicium et germanium de type Si₁₋ₓ₁Geₓ₁, avec X1 compris strictement entre 0 et Xf, microstructure caractérisée en ce qu'elle comporte une seconde couche initiale en alliage de silicium et germanium de type Si_{1-X2}Ge_{X2}.

### Objet de l'invention

L'invention a pour but de remédier à l'ensemble des inconvénients précités et a pour objet la réalisation d'une microstructure destinée à la formation d'un substrat en silicium et germanium sur isolant et de type Si_{1-Xf}Ge_{Xf}, qui soit épais et qui présente des propriétés mécaniques optimales.

Selon l'invention, ce but est atteint par une microstructure selon les revendications annexées et, plus particulièrement, par le fait que la microstructure comporte une seconde couche initiale en alliage de silicium et germanium de type Si_{1-X2}Ge_{X2}, avec X2 compris entre une première valeur non nulle et 1, et une couche intercalaire en oxyde de silicium ou en nitrure de silicium, apte à rester amorphe lors de la formation du substrat et formée entre la première couche initiale en alliage de silicium et germanium de type Si_{1-X1}Ge_{X1} et la seconde couche initiale en alliage de silicium et germanium de type Si_{1-X2}Ge_{X2}.

L'invention a également pour objet l'utilisation d'une telle microstructure, plus particulièrement, pour la fabrication d'un substrat en SGOI ou en GOI par la technique de condensation germanium.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente schématiquement une vue en coupe d'une microstructure selon l'art antérieur, destinée à la formation d'un substrat en silicium et germanium sur isolant et de type Si_{1-Xf}Ge_{Xf}
La figure 2 représente schématiquement une vue en coupe du substrat obtenu par condensation germanium à partir de la microstructure selon la figure 1.
La figure 3 représente schématiquement une vue en coupe d'une microstructure selon l'invention, destinée à la formation d'un substrat en silicium et germanium sur isolant et de type Si_{1-Xf}Ge_{Xf}.
La figure 4 représente schématiquement une vue en coupe d'une étape intermédiaire d'un procédé de condensation germanium à partir de la microstructure selon la figure 3, pour former un substrat en silicium et germanium sur isolant et de type Si_{1-Xf}Ge_{Xf}.
La figure 5 représente schématiquement une vue en coupe du substrat obtenu par condensation germanium à partir de la microstructure selon la figure 3.
La figure 6 représente schématiquement une vue en coupe d'une variante de réalisation d'une microstructure selon l'invention, destinée à la formation d'un substrat en silicium et germanium sur isolant et de type Si_{1-Xf},Ge_{Xf}.
La figure 7 représente schématiquement une vue en coupe du substrat obtenu par condensation germanium à partir de la microstructure selon la figure 6.
La figure 8 représente schématiquement une vue en coupe d'une autre variante de réalisation d'une microstructure selon l'invention, destinée à la formation d'un substrat en silicium et germanium sur isolant et de type Si_{1-Xf}Ge_{Xf}.

### Description de modes particuliers de réalisation

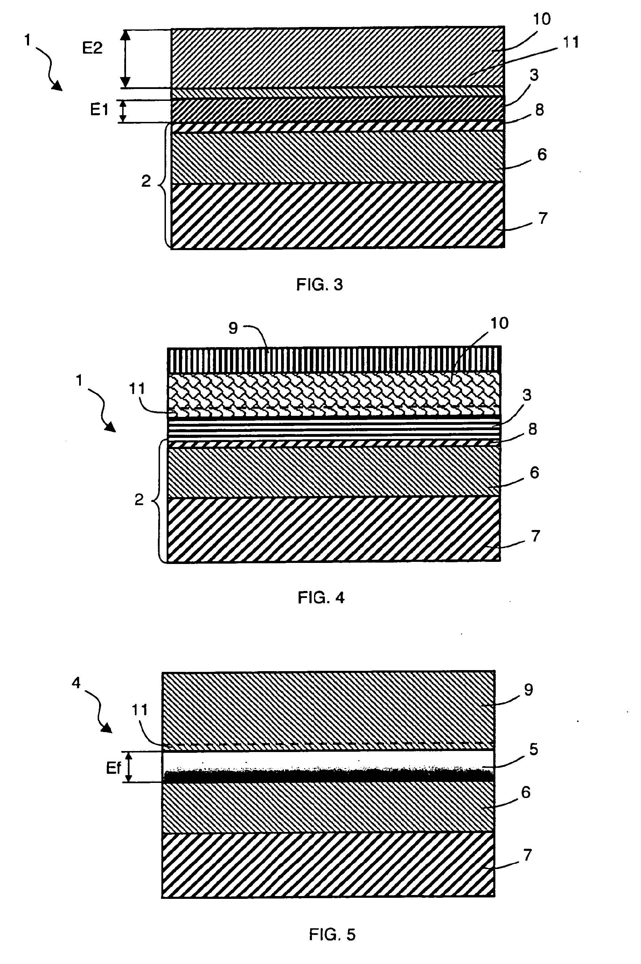

Sur la figure 3, la microstructure 1 est formée par un empilement d'un substrat 2 en SOI et d'une première couche 3 initiale en alliage de silicium et germanium de type Si_{1-X1}Ge_{X1}. La couche 3 en Si_{1-X1}Ge_{X1} est, de préférence, pseudomorphe, à savoir avec une épaisseur E1 inférieure à l'épaisseur critique de relaxation plastique.

La microstructure 1 comporte une seconde couche 10 initiale en alliage de silicium et germanium de type Si_{1-X2}Ge_{X2}, avec X2 compris entre une première valeur non nulle et 1. La concentration X2 en germanium de la seconde couche 10 initiale est, de préférence, distincte de la concentration X1 en germanium de la première couche 3 initiale.

Dans le cas où là concentration X2 et égale à 1, la seconde couche 10 initiale est en germanium pur et, dans le cas où la concentration X2 est comprise strictement entre 0 et 1, la seconde couche 10 initiale est en alliage de silicium et germanium.

La couche 10 en Si_{1-X2}Ge_{X2} est, de préférence, amorphe ou polycristalline et présente une épaisseur E2, de préférence, supérieure à l'épaisseur E1 de la première couche 3 initiale en Si_{1-X1}Ge_{X1}. D'une façon générale, pour éviter la présence de dislocation dans la microstructure 1, la couche 10 en Si_{1-X2}Ge_{X2} est non monocristalline, de sorte que la couche 10 en Si_{1-X2}Ge_{X2} ne rentre pas en compte dans l'épaisseur critique de relaxation plastique de la microstructure 1.

La microstructure 1 est destinée à servir de structure de départ pour la formation d'un substrat 4 épais (figure 5), comprenant une couche 5 finale en alliage de silicium et germanium de type Si_{1-Xf}Ge_{Xf}. La microstructure 1 est, plus particulièrement, destinée à former un substrat 4, dont l'épaisseur finale Ef de la couche 5 en Si_{1-Xf}Ge_{Xf} est supérieure à l'épaisseur initiale E1 de la couche 3 en Si_{1-X1}Ge_{X1} (figures 3 et 5).

La concentration initiale X1 de germanium dans la première couche 3 en Si_{1-X1}Ge_{X1} est, de préférence, comprise strictement entre 0 et Xf. La concentration final Xf de germanium est comprise strictement entre 0 et 1, pour un substrat 4 en SGOI, et la concentration finale Xf de germanium est égale à 1, pour un substrat 4 en GOI.

La microstructure 1 est plus particulièrement destinée à être utilisée comme structure de départ, lors d'un procédé de condensation germanium, permettant de réaliser un substrat 4 avec une couche 5 épaisse en Si_{1-Xf}Ge_{Xf} et dont les principales étapes sont représentées sur les figures 4 et 5.

Dans le mode particulier de réalisation représenté sur la figure 3, la microstructure 1 comporte également une couche intercalaire 11, formée entre la première couche 3 initiale en Si_{1-X1}Ge_{X1} et la seconde couche 10 initiale en Si_{1-X2}Ge_{X2}. La couche intercalaire 11 doit être suffisamment épaisse, notamment pour permettre le dépôt de la seconde couche 10 initiale, et suffisamment fine, notamment pour autoriser la diffusion des atomes de germanium, dans le cas de l'utilisation de la microstructure 1 pour former un substrat 4 par un procédé de condensation germanium. À titre d'exemple, la couche intercalaire 11 a une épaisseur de l'ordre de quelques angströms à quelques nanomètres.

La couche intercalaire 11 est apte à rester amorphe lors de la formation du substrat 4, notamment lors d'un traitement à haute température du type oxydation thermique du procédé de condensation germanium. La couche intercalaire 11 permet notamment d'éviter la cristallisation de la seconde couche 10 initiale en Si_{1-X2}Ge_{X2}, lors de la montée en température inhérente à l'étape d'oxydation thermique du procédé de condensation germanium. La seconde couche 10 initiale en Si_{1-X2}Ge_{X2} reste ainsi amorphe ou polycristalline, pendant la formation du substrat 4.

Dans le mode particulier de réalisation de la figure 3, la couche intercalaire 11 est en oxyde de silicium SiO₂. L'oxyde de la couche intercalaire 11 peut être formé par voie chimique (bain d'ozone + acide chlorhydrique; acide sulfurique) ou par voie thermique (oxygène, vapeur d'eau, vapeur d'eau + acide chlorhydrique ; température de l'ordre de 800°C à 1100°C). L'oxyde de la couche intercalaire 11 peut être natif, à savoir formé naturellement, ou peut être déposé, à savoir par dépôt direct d'une couche, par exemple, d'oxyde de silicium SiO₂.

Dans le mode particulier de réalisation des figures 3 à 5, la technique de condensation germanium consiste à effectuer une oxydation thermique, de préférence à haute température, de l'ensemble des couches 2, 3, 10 et 11 de l'empilement constituant la microstructure 1 de départ (figure 3). Comme représenté sur la figure 4, pendant l'étape d'oxydation thermique, le silicium de la seconde couche 10 initiale en Si_{1-X2}Ge_{X2} et de la couche intercalaire 11 en SiO₂ est oxydé et les atomes de germanium sont diffusés vers la première couche 3 initiale en Si_{1-X1}Ge_{X1}.

Le silicium de la couche fine 8 du substrat 2 en SOI, de la première couche 3 en Si_{1-X1}Ge_{X1} et de la seconde couche 10 en Si_{1-X2}Ge_{X2} remonte vers le haut de l'empilement des couches et commence à former la couche supérieure 9 d'oxyde de silicium SiO₂ sur le dessus de l'empilement (figure 4).

L'épaisseur de la couche fine 8 de silicium et de la seconde couche 10 initiale de la microstructure 1 diminuent et l'épaisseur de la couche 9 de SiO₂ formée sur le dessus de l'empilement augmente au fur et à mesure de l'oxydation thermique. Le procédé de condensation germanium continue tant que la concentration finale recherchée de germanium Xf de la couche 5 du substrat 4 n'est pas atteinte.

Comme représenté sur la figure 5, à la fin du traitement de condensation germanium, la couche 5 enrichie en germanium du substrat 4 ainsi obtenu, est soit en germanium pur, s'il y a consommation complète du silicium, soit en alliage de silicium et germanium, s'il y a consommation incomplète du silicium. Le substrat 4 comporte la couche 5 en Si_{1-Xf}Ge_{Xf}, rejetée contre la couche 6 de SiO₂ enterrée, et la couche supérieure 9 de SiO₂, formée sur le dessus de la couche finale 5 et comprenant la couche 11 en SiO₂ restée amorphe pendant la formation du substrat 4. L'épaisseur finale Et de la couche 5 en Si_{1-Xf}Ge_{Xf}, supérieure à l'épaisseur E1 de la couche 3 initiale en Si_{1-X1}Ge_{X1} de la microstructure 1, est relativement épaisse, notamment pour permettre la formation de composants sur le dessus du substrat 4.

La seconde couche 10 initiale en Si_{1-X2}Geₓ₂ de la microstructure 1 (figure 3) a ainsi servi de réservoir de germanium, conduisant à un enrichissement plus rapide de la couche 5 du substrat 4 et entraînant l'obtention d'une couche 5 très épaisse, évitant toute étape d'épaississement supplémentaire.

À titre d'exemple, en considérant qu'il y a conservation totale des atomes de germanium pendant le traitement de condensation germanium, on peut écrire l'équation suivante : X1.E1 + X2.E2 = Xf.Ef

Ainsi, une microstructure 1 selon l'art antérieur, avec une concentration X1 de germanium de l'ordre de 10% (X1=0,1) et une épaisseur E1 de la couche 3 en Si_{1-X1}Ge_{X1} de l'ordre de 100nm, permet de réaliser un substrat 4 en GOI avec une couche 5 en germanium pur, à savoir avec une concentration Xf de 100% (Xf=1), ayant une épaisseur Ef de l'ordre de 10nm.

Une microstructure 1 selon l'invention, avec la même première couche 3 initiale et avec la seconde couche 10 initiale, avec une concentration X2 de germanium de l'ordre de 30% (X2=0,3) et une épaisseur E2 de l'ordre de 100nm, permet de réaliser un substrat 4 en GOI avec une couche 5 en germanium pur, à savoir avec une concentration Xf de 100% (Xf=1 ), ayant une épaisseur finale Ef de l'ordre de 40nm. La couche finale 5 obtenue est donc quatre fois plus épaisse que la couche initiale 3 de la microstructure 1 de départ, en utilisant une microstructure 1 selon l'invention.

Une telle microstructure 1 avec une couche 10 initiale supplémentaire dans l'empilement de couches de la microstructure 1, notamment pour la réalisation d'un substrat 4 par condensation germanium, permet donc d'obtenir un substrat 4 en SGOI ou GOI épais, directement après la condensation germanium. La couche 5 est relativement épaisse et présente des caractéristiques optimales en termes d'enrichissement en germanium.

Par ailleurs, la présence de la couche intercalaire 11 permet d'éviter la cristallisation de la seconde couche 10, lors du procédé de condensation germanium. Il en résulte l'obtention d'un substrat 4 présentant des caractéristiques optimales en termes de propriétés mécaniques, notamment un substrat 4 présentant aucun défaut cristallin.

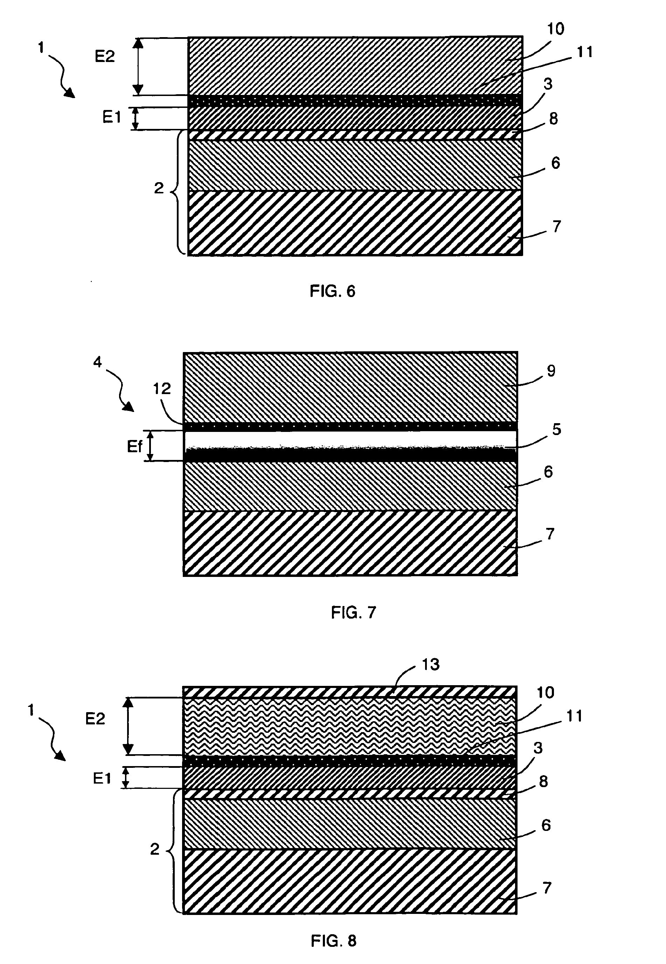

La variante de réalisation de la microstructure 1 représentée sur la figure 6 se distingue du mode de réalisation de la figure 3 par la couche intercalaire 11 en nitrure de silicium Si₃N₄. Dans le cas de la formation d'un substrat 4 par un procédé de condensation germanium, comme représenté sur la figure 7, il subsiste alors à la fin du procédé une couche résiduelle 12 d'oxynitrure de silicium entre la couche finale 5 enrichie en germanium et la couche supérieure 9 en SiO₂ formée après condensation germanium. Selon les applications, cette couche résiduelle 12 est ensuite éliminée, par exemple lors du processus final de réalisation d'un composant à partir du substrat 4 ainsi formé.

Sur la figure 8, la variante de réalisation de la microstructure 1 se distingue des modes de réalisation représentés sur les figures 3 et 6, par l'empilement d'une couche additionnelle 13 de silicium, formée sur la deuxième couche 10 initiale en Si_{1-X2}Ge_{X2} de la microstructure 1. La couche additionnelle 13 de silicium est notamment déposée avant tout traitement d'oxydation thermique, dans le cas de l'utilisation de la microstructure 1 pour un traitement de condensation germanium.

La couche additionnelle 13 de silicium, avec une épaisseur, par exemple, de l'ordre de quelques angströms à quelques nanomètres, est, de préférence, amorphe ou polycristalline et sert notamment à former une fine couche de SiO₂ sur le dessus de la microstructure 1, empêchant la consommation de germanium lors de l'étape d'oxydation thermique du procédé de condensation germanium.

Quel que soit le mode de réalisation de la microstructure 1 décrit ci-dessus, une telle microstructure 1 permet notamment de fabriquer un substrat 4 en GOI ou en SGOI présentant des caractéristiques optimales en termes de concentration et d'enrichissement de germanium, en termes d'épaisseur de couches et termes de propriétés mécaniques.

La présence d'une seconde couche 10 initiale dans la microstructure 1 de départ, notamment lors de l'utilisation de la microstructure 1 pour former un substrat 4 par condensation germanium, permet d'accélérer l'enrichissement en germanium et d'obtenir un substrat 4 avec de meilleures qualités. La seconde couche 10 initiale permet également d'éviter toute étape supplémentaire d'épaississement du substrat 4. Par ailleurs, la couche intercalaire 11 permet notamment d'empêcher la cristallisation de la couche 10, qui reste amorphe ou polycristalline pendant la formation du substrat 4.

De plus, la première couche 3 initiale, fine et pseudomorphe, permet notamment d'éviter la présence de dislocations dans l'empilement de couches d'une telle microstructure 1.

L'invention n'est pas limitée aux différents modes de réalisation décrits ci-dessus. Les valeurs des concentrations de germanium et des épaisseurs de couches sont non limitatives et dépendent des caractéristiques initiales et finales souhaitées de la microstructure 1 et du substrat 4.

## Revendications

1. Microstructure (1) destinée à la formation d'un substrat (4) en silicium et germanium sur isolant et de type Si_{1-Xf}Ge_{Xf}, avec Xf compris entre une première valeur non nulle et 1, et formée par un empilement d'un substrat (2) en silicium sur isolant et d'une première couche (3) initiale en alliage de silicium et germanium de type Si_{1-X1}Ge_{X1}, avec X1 compris strictement entre 0 et Xf,
microstructure **caractérisée en ce qu'**elle comporte une seconde couche (10) initiale en alliage de silicium et germanium de type Si_{1-X2}Ge_{X2}, avec X2 compris entre une première valeur non nulle et 1, et une couche intercalaire (11), apte à rester amorphe lors de la formation du substrat (4) et formée entre la première couche (3) initiale en alliage de silicium et germanium de type Si_{1-X1}Ge_{X1} et la seconde couche (10) initiale en alliage de silicium et germanium de type Si_{1-X2}Ge_{X2} et **en ce que** la couche intercalaire (11) est en oxyde de silicium ou en nitrure de silicium.

2. Microstructure selon la revendication 1, **caractérisée en ce que** l'épaisseur de la couche intercalaire (11) est de l'ordre de quelques angströms à quelques nanomètres.

3. Microstructure selon l'une des revendications 1 et 2, **caractérisée en ce que** la première couche (3) initiale en alliage de silicium et germanium de type Si_{1-X1}Ge_{X1} est pseudomorphe.

4. Microstructure selon l'une quelconque des revendications 1 à 3, **caractérisée en ce que** la seconde couche (10) initiale en alliage de silicium et germanium de type Si_{1-X2}Ge_{X2} est amorphe.

5. Microstructure selon l'une quelconque des revendications 1 à 3, **caractérisée en ce que** la seconde couche (10) initiale en alliage de silicium et germanium de type Si_{1-X2}Ge_{X2} est polycristalline.

6. Microstructure selon l'une quelconque des revendications 1 à 5, **caractérisée en ce qu'**elle comporte une couche additionnelle (13) de silicium, déposée sur la seconde couche (10) initiale en alliage de silicium et germanium de type Si_{1-X2}Ge_{X2}.

7. Utilisation d'une microstructure (1) selon l'une quelconque des revendications 1 à 6, pour la fabrication par condensation germanium d'un substrat (4) épais en silicium et germanium sur isolant et de type Si_{1-Xf}Ge_{Xf}.

## Claims

1. Microstructure (1) designed for formation of a silicon and germanium on Insulator substrate (4) of Si_{1-Xf}Ge_{Xf} type, with Xf comprised between a first value that is not zero and 1, and formed by stacking of a silicon on Insulator substrate (2), a first initial layer (3) of silicon and germanium alloy of Si_{1-X1} Ge_{X1} type, with X1 strictly comprised between 0 and Xf,
microstructure **characterized in that** it comprises a second initial layer (10) of silicon and germanium alloy of Si_{1-X2}Ge_{X2} type, with X2 comprised between a first value that is not zero and 1, an intermediate layer (11) that is able to remain amorphous during formation of the silicon and germanium on insulator substrate, and formed between the first initial layer (3) of silicon and germanium alloy of Si_{1-X1}Ge_{X1} type and the a second Initial layer (10) of silicon and germanium alloy of Si_{1-X2}Ge_{X2} type and **in that** the intermediate layer (11) is made of silicon oxide or silicon nitride

2. Microstructure according to claim 1, **characterized in that** the thickness of the intermediate layer (11) ranges from a few angstroms to a few nanometers.

3. Microstructure according to one of the claims 1 and 2, **characterized in that** the first initial layer (3) of silicon and germanium alloy of Si_{1-X1}Ge_{X1} type is pseudomorphous.

4. Microstructure according to anyone of the claims 1 to 3, **characterized in that** the second initial layer (10) of silicon and germanium alloy of S_{1-X2}Ge_{X2} type is amorphous.

5. Microstructure according to anyone of the claims 1 to 3, **characterized in that** the second initial layer (10) of silicon and germanium alloy of Si_{1-X2}Ge_{X2} type is polycrystalline.

6. Microstructure according to anyone of the claims 1 to 5, **characterized In that** it comprises an additional silicon layer (13) deposited on the second initial layer (10) of silicon and germanium alloy of Si_{1-X2}Ge_{X2} type.

7. Use of a microstructure according to anyone of the claims 1 to 6, for fabrication by germanium condensation of a thick silicon and germanium on insulator substrate (4) of Si_{1-Xf}Ge_{Xf} type.

## Patentansprüche

1. Mikrostruktur (1) zur Bildung eines Substrats (4) aus Silizium und Germanium auf einem Isolator und vom Typ Si_{1-Xf}Ge_{Xf}, wobei Xf einen Wert von ungleich Null bis 1 aufweist, und gebildet durch eine Aufschichtung eines Siliziumsubstrats (2) auf einem Isolator einer ersten Ausgangsschicht (3) aus einer Silizium-Germanium-Legierung vom Typ Si_{1-X1}Ge_{X1}, wobei der Wert von X1 strikt 0 bis Xf beträgt,
Mikrostruktur, die **dadurch gekennzeichnet ist, dass** sie eine zweite Ausgangsschicht (10) aus einer Silizium-Germanium-Legierung vom Typ Si_{1-X2}Ge_{X2} umfasst, wobei X2 einen Wert von ungleich Null bis 1 aufweist, sowie eine Zwischenschicht (11) aufweist, die geeignet ist, bei der Herstellung des Substrats (4) amorph zu bleiben, und zwischen der ersten Ausgangsschicht (3) aus einer Silizium-Germanium-Legierung vom Typ Si_{1-X1} Ge_{X1} und der zweiten Ausgangsschicht (10) aus einer Silizium-Germanium-Legierung vom Typ Si_{1-X2}Ge_{X2} gebildet ist, sowie **dadurch**, dass die Zwischenschicht (11) aus Siliziumoxid oder Siliziumnitrid besteht.

2. Mikrostruktur nach Anspruch 1, **dadurch gekennzeichnet, dass** die Dicke der Zwischenschicht (11) in der Größenordnung von einigen Ångström bis einigen Nanometern liegt.

3. Mikrostruktur nach einem der Ansprüche 1 und 2, **dadurch gekennzeichnet, dass** die erste Ausgangsschicht (3) aus einer Silizium-Germanium-Legierung vom Typ Si_{1-X1}Ge_{X1} pseudomorph ist.

4. Mikrostruktur nach einem der Ansprüche 1 bis 3, **dadurch gekennzeichnet, dass** die zweite Ausgangsschicht (10) aus einer Silizium-Germanium-Legierung vom Typ Si_{1-X2}Ge_{X2} amorph ist.

5. Mikrostruktur nach einem der Ansprüche 1 bis 3, **dadurch gekennzeichnet, dass** die zweite Ausgangsschicht (10) aus einer Silizium-Germanium-Legierung vom Typ Si_{1-X2}Ge_{X2} polykristallin ist.

6. Mikrostruktur nach einem der Ansprüche 1 bis 5, **dadurch gekennzeichnet, dass** die eine zusätzliche Schicht (13) aus Silizium umfasst, die auf die zweite Ausgangsschicht (10) aus einer Silizium-Germanium-Legierung vom Typ Si_{1-X2} Ge_{X2} aufgebracht ist.

7. Verwendung einer Mikrostruktur (1) nach einem der Ansprüche 1 bis 6, zur Herstellung eines dicken Substrats (4) aus Silizium und Germanium auf einem Isolator und vom Typ Si_{1-X1}Ge_{X1} durch GermaniumKondensation.
